Europäisches Patentamt

European Patent Office

Office européen des brevets

(19)

(11) EP 0 703 648 A1

(12) DEMANDE DE BREVET EUROPEEN

(43) Date de publication:
27.03.1996 Bulletin 1996/13

(51) Int Cl.⁶: H01S 3/109

(21) Numéro de dépôt: 95402100.2

(22) Date de dépôt: 19.09.1995

(84) Etats contractants désignés:
DE GB NL

(30) Priorité: 23.09.1994 FR 9411376

(71) Demandeur: THOMSON-CSF
F-75008 Paris (FR)

(72) Inventeurs:
• Delacourt, Dominique
F-92402 Courbevoie Cedex (FR)

• Papuchon, Michel
F-92402 Courbevoie Cedex (FR)
• Lallier, Eric
F-92402 Courbevoie Cedex (FR)
• Debuisschert, Thierry
F-92402 Courbevoie Cedex (FR)

(74) Mandataire: Guérin, Michel et al
THOMSON-CSF
SCPI
B.P. 329
50, rue Jean-Pierre Timbaud
F-92402 Courbevoie Cédex (FR)

(54) Doubler de fréquence optique compacte et auto-stabilisée

(57)    L'invention concerne une source optique compacte capable d'émettre des longueurs d'onde difficilement accessibles par les diodes lasers classiques (bleu notamment). Cette source comprend un laser (ou diode laser) émettant à $\lambda o_i$, un milieu non linéaire (MNL) dans lequel la condition d'accord de phase est réalisée à une longueur d'onde $\lambda o_a$ appartenant à l'ensemble de $\lambda o_i$, un miroir ($M_1$) transparent à $\lambda o_i/2$ et réfléchissant à $\lambda o_i$ placé en sortie du milieu (MNL). En réinjectant au sein du laser des longueurs d'onde $\lambda o_i \neq \lambda o_a$, il est possible de verrouiller l'émission du laser à $\lambda o_a$ et ainsi réaliser une source optique à $\lambda o_a/2$ de puissance élevée.
    Application: Source bleue

FIG.4

EP 0 703 648 A1

## Description

Le domaine de l'invention est celui des sources optiques compactes, capables d'émettre dans des domaines spectraux que l'absence de matériaux lasers adaptés ou la difficulté pour les obtenir pourraient interdire, et ce grâce à des opérations de conversion de fréquence.

En effet, en utilisant la susceptibilité non linéaire d'ordre deux de certains matériaux tels que par exemple le niobate de lithium ($LiNbO_3$), on peut à partir d'une illumination dans le proche infrarouge, émettre dans la région bleue du spectre, grâce au phénomène de doublage de fréquence.

Dans l'opération de doublage de fréquence, pour que soit efficace le transfert de puissance optique à partir de l'illumination incidente à la longueur d'onde $\lambda$, il est nécessaire que dans le matériau et tout au long de l'interaction, la polarisation non linéaire induite par l'onde incidente soit en accord de phase avec l'onde créée à la longueur d'onde $\lambda/2$ et que l'on cherche à alimenter. Cependant, en général et du fait de la dispersion des indices de réfraction du matériau à $\lambda^\omega$ et $\lambda^\omega/2$, cette condition d'accord de phase n'est pas satisfaite d'emblée.

Pour contourner cet obstacle, une première solution consiste à mettre à profit la biréfringence de certains matériaux afin de compenser leur dispersion d'indice. Il existe également une solution alternative qui consiste à utiliser le Quasi-Accord de Phase (Q A P) applicable dans des conditions beaucoup plus générales que celles concernant la biréfringence de certains matériaux. Cette solution alternative consiste à perturber périodiquement l'interaction non linéaire afin de compenser la différence de vecteur d'onde responsable du désaccord de phase.

Plus précisément, soit une onde incidente, se propageant suivant l'axe Ox dans le matériau non linéaire et de champs électriques

$$E\omega = E\omega, o \; e^{j(\omega t - \beta_\omega x + \varphi p_o)}$$

de longueur d'onde $\lambda^\omega = 2\pi.c/\omega$

$\varphi_{po}$ déphasage de l'onde de pompe

avec $\beta_\omega$ constante de propagation de l'onde de pompe et $\beta_\omega = 2\pi n_\omega/\lambda^\omega$

c : la célérité de la lumière dans le vide

$\omega$ : la fréquence

Dans un matériau adapté, cette onde peut donner naissance à une polarisation non linéaire d'ordre 2, s'écrivant

$$P_{NL} = \varepsilon_o \; d \; E_\omega{}^2 = \varepsilon_o \; d \; E_{\omega,o}{}^2 e^{j(2\omega t - 2\beta_\omega x + 2\varphi_{po})}$$

avec $\varphi_{po}$ déphasage de l'onde de pompe, avant réflexion sur le miroir

où d est le coefficient non linéaire mis en jeu et $\varepsilon_o$ la permittivité diélectrique du vide.

Cette polarisation rayonne une onde à fréquence double susceptible de construire au fur et à mesure de l'interaction, un faisceau harmonique de longueur d'onde moitié $\lambda^{2\omega} = \lambda^\omega /2$ et de constante de propagation $\beta_{2\omega}$

avec $\beta_{2\omega} = 2\pi \, n_{2\omega}/\lambda^{2\omega}$ où $n_{2\omega}$ est l'indice du matériau à la longueur d'onde $\lambda^{2\omega}$ ; le champ électrique correspondant à cette onde peut s'écrire

$$E_{2\omega} = E_{2\omega,o} \, e^{j(2_\omega t - \beta_{2\omega} x + \varphi_{ho})}$$

avec $\varphi_{ho}$ déphasage de l'onde harmonique avant réflexion sur le miroir.

Il apparaît ainsi que le déphasage $\Delta\phi$ entre la polarisation non linéaire qui constitue la source du rayonnement à $\lambda^{2\omega}$, et l'onde harmonique que l'on cherche à alimenter de manière constructive à l'aide de cette polarisation, va jouer un rôle décisif dans la conversion $\lambda^\omega \dashrightarrow \lambda^{2\omega}$. En fait ce déphasage s'exprime au bout d'une distance x d'interaction, de la manière suivante :

$$\Delta\varphi = (\beta_{2\omega} - 2\beta_\omega)x = \Delta\beta x \text{ avec } \Delta\beta = 4\pi(n_{2\omega} - n_\omega)\lambda^\omega = 4\pi\Delta n/\lambda^\omega$$

Il apparaît bien qu'en raison de la dispersion des indices, ce déphasage n'est généralement pas nul.

Cependant on peut créer une variation périodique $\Delta\beta = m.K$ ou $K = 2\pi/\Lambda$ avec $\Lambda$ période de la perturbation, et $\Lambda = 2L_C$ si $L_C$ est la longueur de cohérence correspondant à la distance d'interaction au bout de laquelle polarisation et onde harmonique ont accumulé un déphasage de $\pi$.

La perturbation peut être introduite au niveau de tout paramètre intervenant dans l'interaction non linéaire (indice de réfraction, dispersion des indices, coefficient non linéaire mis en jeu ...).

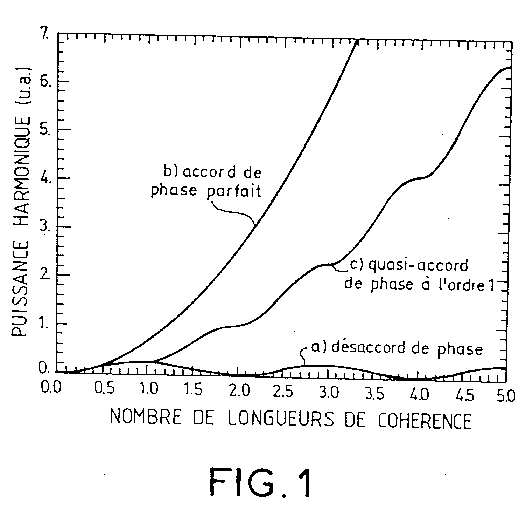

Grâce à cette perturbation périodique, le déphasage $\Delta\varphi$ entre polarisation et onde harmonique se voit diminuer de $\pi$ au bout de chaque $L_C$, c'est-à-dire qu'au lieu de continuer à s'accumuler, il est ramené à 0, toutes les longueurs de cohérence. La figure 1 illustre à ce titre les trois cas possibles : courbe a) désaccord de phase, courbe b) : quasi accord de phase, courbe c) : accord de phase parfait.

L'objet de l'invention concerne une source utilisant un laser émettant une onde incidente à $\lambda^\omega$ de manière à générer par l'intermédiaire d'un doubleur de fréquence une onde $\lambda^{2\omega}$ ; le doubleur de fréquence étant un milieu non linéaire (MNL) dans lequel la condition d'accord de phase, ou la condition de quasi accord de phase est réalisée à la longueur d'onde $\lambda^\omega$.

La source selon l'invention permet de résoudre le problème de la largeur spectrale d'émission du laser, ce phénomène étant prononcé dans le cadre de diode laser, alors que les conditions d'accord de phase ou de quasi accord de phase ne sont satisfaites dans le milieu (MNL) que pour certaines longueurs d'onde très précises.

Pour cela, la source compacte selon l'invention utilise le "verrouillage" de la longueur d'onde d'émission du laser en injectant à ce dernier un signal de longueurs d'onde données.

L'invention repose sur la constatation amenée empiriquement suivante :

Lorsque l'on utilise une diode laser pour pomper un laser guide d'onde du type : Nd:MgO:LiNbO$_3$ décrit dans la référence ("Nd:MgO:LiNbO$_3$ channel waveguide laser devices", E. LALLIER, J.P. POCHOLLE, M. PAPUCHON, M. de MICHELI, M.J. LI, Q. HE, D.B. OSTROWSKY, C. GREZES-BESSET and E. PELLETIER, IEEE J. Quantum Electron. 27 (3), pp 618-625, 1991), la diode laser vient verrouiller sa longueur d'onde d'émission automatiquement sur la valeur correspondant au maximum d'absorption du néodyme dans LiNbO$_3$.

Il en ressort qu'il est possible de verrouiller la longueur d'onde d'émission d'un laser émettant une onde incidente dans une gamme de longueurs d'onde $\lambda o_i$, à la longueur d'onde $\lambda o_a$ en réinjectant au sein dudit laser une onde lumineuse dont le niveau énergétique à la longueur d'onde $\lambda o_a$ est fortement dépeuplé par rapport aux niveaux énergétiques aux longueurs d'onde $\lambda o_i \neq \lambda o_a$.

Ainsi l'invention exploite ce phénomène pour verrouiller l'émission du laser servant à alimenter le milieu (MNL) doubleur de fréquence, à la longueur d'onde $\lambda o_a$ pour laquelle la condition d'accord de phase ou de quasi accord de phase est satisfaite au sein dudit milieu (MNL).

En effet, dans l'opération de doublage de fréquence, la puissance harmonique engendrée est directement prélevée à la puissance de l'onde de pompe et lorsque le rendement de conversion devient notable, le dépeuplement de l'onde de pompe devient lui-même sensible, en l'occurence à la longueur d'onde $\lambda o_a$.

C'est pourquoi l'invention a précisément pour objet une source optique compacte, comprenant un laser émettant une onde incidente dans une gamme de longueurs d'onde $\lambda o_i$, un milieu non linéaire (MNL), caractérisée en ce que :

- la condition d'accord de phase permettant d'annuler ou de compenser la différence de constante de propagation existant entre la polarisation non linéaire créée par l'onde incidente d'une part et l'onde harmonique engendrée par cette polarisation d'autre part, est réalisée à la longueur d'onde $\lambda o_a$ appartenant à l'ensemble des $\lambda o_i$, dans le milieu (MNL) ;

- la source optique comprend également un miroir dichroïque M$_1$ situé de telle manière que le milieu (MNL) est compris entre le laser et le miroir, ledit miroir étant fortement réfléchissant à $\lambda o_i$ et fortement transparent à $\lambda o_i/2$ de façon à réinjecter dans le laser une onde lumineuse dont le niveau énergétique à la longueur d'onde $\lambda o_a$ est fortement dépeuplé par rapport aux niveaux énergétiques aux longueurs d'onde $\lambda o_i \neq \lambda o_a$.

Dans la source optique compacte selon l'invention, le laser peut avantageusement être une diode laser.

La condition d'accord de phase peut être assurée par la biréfringence du milieu (MNL) dans certaines gammes de longueurs d'onde, avec certains milieux non linéaires type LiNbO$_3$.

Pour des longueurs d'ondes d'émission non compatibles avec les matériaux non linéaires biréfringents classiques, la condition de quasi accord de phase peut être assurée par une variation périodique d'un paramètre physique du milieu (MNL), intervenant dans l'interaction non linéaire, entre la polarisation non linéaire créée et l'onde harmonique.

Le miroir M$_1$ peut avantageusement être intégré au milieu non linéaire (MNL) et notamment dans le cas d'un guide d'onde en face de sortie de ce guide.

Le milieu (MNL) peut avantageusement être du type tantalate de lithium (LiTaO$_3$) ou de type niobate de lithium (LiNbO$_3$) ou de type phosphate de potassium et de titanyl (KTP).

L'invention sera mieux comprise et d'autres avantages apparaîtront à la lecture de la description qui va suivre, donnée à titre non limitatif et des figures annexées parmi lesquelles :

- la figure 1 illustre l'évolution de la puissance harmonique en fonction de la distance d'interaction dans les cas suivants :

     a) de désaccord de phase

     b) d'accord de phase parfait

     c) de quasi accord de phase

- la figure 2 illustre l'évolution de la puissance en fonction de la longueur d'onde de pompe, pour l'onde de pompe (courbe 1) et l'onde harmonique (courbe 2) ;

- la figure 3 schématise le principe de l'invention dans un exemple de configuration possible ;

- la figure 4 illustre un exemple de source optique selon l'invention réalisée en optique guidée.

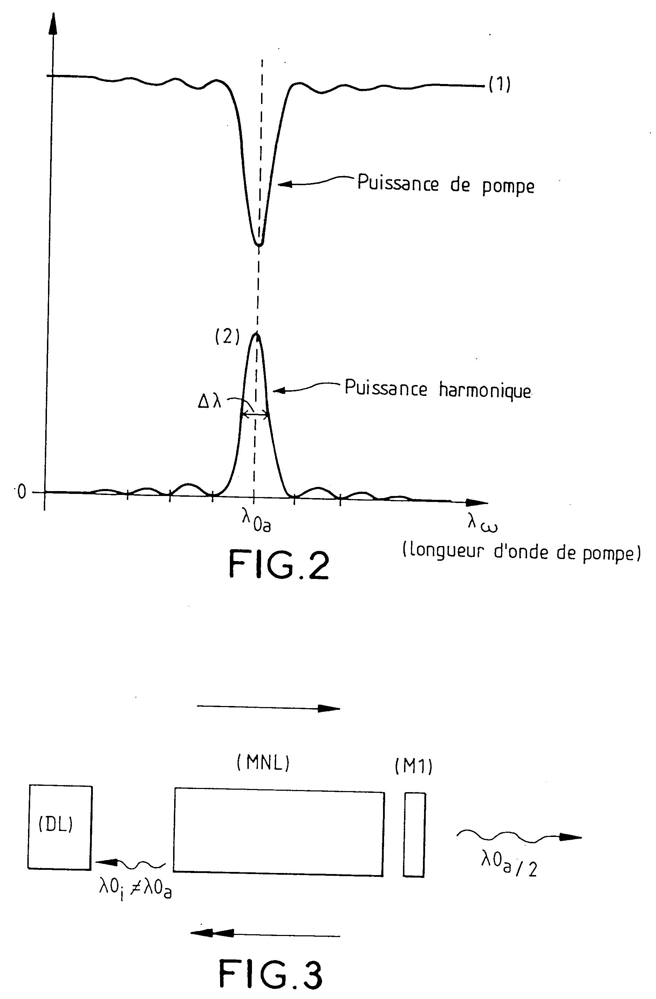

Afin de réaliser une source optique cohérente compacte à des longueurs d'ondes particulièrement recherchées (notamment les sources bleues), l'invention propose d'utiliser un laser, capable de pomper optiquement un milieu non linéaire (MNL) au sein duquel on crée par doublage de fréquence une onde à la fréquence double de celle de l'onde de pompe. Pour obtenir une puissance suffisante à la fréquence double, il est avantageux de bloquer l'émission du laser à la longueur d'onde pour laquelle la condition d'accord de phase est assurée dans le milieu non linéaire (MNL). La figure 2 illustre, en fonction de la longueur d'onde de pompe $\lambda^\omega$, les évolutions associées de la puissance harmonique (courbe 2) et de celle de l'onde de pompe (courbe 1), si la condition d'accord de phase est réalisée à $\lambda o_a$, avec une acceptance spectrale de $\Delta\lambda$.

Il ressort de ces courbes que l'onde de pompe subit un dépeuplement spectralement très sélectif en longueurs d'onde lié au doublage de fréquence.

Le verrouillage du laser, sur la longueur d'onde d'émission préférentiellement à $\lambda o_a$ peut se produire en réinjectant audit laser un signal optique dépourvu de la fine gamme spectrale correspondant à la condition d'accord de phase.

Une des configurations possibles pour mettre en oeuvre l'invention est illustrée à la figure 3.

Un laser et notamment une diode laser (DL) émet un faisceau de longueur d'onde $\lambda^\omega$. Ce faisceau est en partie doublé en fréquence et engendre une onde harmonique lorsque la longueur d'onde d'émission de la diode est proche ou égale à $\lambda o_a$. A la sortie du doubleur (milieu (MNL)) un miroir dichroïque (M₁) permet de renvoyer fortement la puissance pompe, via le milieu (MNL) dans la diode laser, laissant passer l'onde optique créée à la longueur $\lambda o_a/2$ qui peut ainsi être exploitée comme onde optique à une fréquence difficile à obtenir (notamment source bleue). Il est à noter que plus l'émission du laser est centrée sur la longueur d'onde $\lambda o_a$ pour laquelle la condition d'accord de phase est satisfaite, plus la puissance optique recueillie à la longueur d'onde $\lambda o_a/2$ est importante.

Dans le cas d'un milieu non linéaire (MNL) dans lequel la condition d'accord de phase est réelle le miroir de sortie (M₁) doit remplir certaines conditions au niveau des déphasages qu'il crée pour l'onde harmonique à $\lambda o_a/2$ et l'onde à $\lambda o_a$. En effet, dans le sens dit "Aller" matérialisé en figure 3 par la flèche ($\rightarrow$) la conversion entre onde de pompe ($\lambda o_a$) et onde harmonique ($\lambda o_a/2$) conduisant à l'opération de doublage de fréquence est telle que $2\varphi_{po} - \varphi_{ho} = -\pi/2$ ① pour conserver cette opération de doublage de fréquence dans le sens dit "Retour" matérialisé en figure 3 par la flèche ($\leftarrow$), il est nécessaire que le miroir (M₁) n'introduise pas des déphasages $\varphi_p$ et $\varphi_h$ respectivement sur l'onde de pompe et l'onde harmonique tels qu'ils satisfassent à la relation $2\varphi_p - \varphi_p = \pi$ ② En effet, dans un tel cas de figure la relation de phase entre $\varphi_{po}$ et $\varphi_{ho}$ devient la relation $2\varphi_{po} - \varphi_{ho} = -\pi/2$ ③ et l'amplification paramétrique conduisant au dépeuplement de l'onde à la fréquence double se réalise au dépens de l'opération de doublage de fréquence. Or le but recherché est d'introduire au niveau du laser (ou diode laser) le niveau énergétique le plus faible possible pour verrouiller la longueur d'onde d'émission à la longueur d'onde $\lambda o_a$.

Dans le cas d'un milieu non linéaire (MNL) dans lequel la condition de quasi-accord de phase est satisfaite, plusieurs cas de figures sont à envisager au niveau des déphasages $\varphi_p$ et $\varphi_h$ introduits par le miroir (M₁) dans le cas où ce miroir n'est pas un miroir parfait capable de transmettre intégralement l'onde harmonique.

Dans un premier cas de figure où $\varphi_h = \varphi_p = 0$, l'opération de dépeuplement de la pompe se poursuit dans le sens "retour" et la condition $\varphi$ est satisfaite dans les sens "Aller" et "Retour".

Dans un second cas de figure où le miroir (M₁) introduit des déphasages tels que :

$$\varphi_h = \varphi_p = +/-\pi$$

ou $\varphi_p = 0$ et $\varphi_h = +/-\pi$

Il se produit une ré-amplification de la pompe au début de l'interaction dans le sens "Retour". Cette ré-amplification de la pompe se traduit par un dépeuplement de l'onde harmonique renvoyée dans le milieu (MNL), compte tenu de la très faible puissance de cette onde, ce dépeuplement conduit rapidement au cours de la propagation dans le sens "Retour", à la quasi disparition de l'onde harmonique. A partir de ce point, on assiste à une inversion de tendance et donc un redémarrage du doublage de fréquence qui vient à nouveau contribuer au dépeuplement de pompe escompté. Il est à noter, et c'est un point fondamental, que cette inversion de tendance qui se produit d'elle-même et qui constitue un avantage notable, n'existe que dans le cas où la technique d'accord de phase utilisée est du type artificiel (QAP). Dans ce cas là, quels que soient les déphasages $\varphi_p$ et $\varphi_h$ introduits par le miroir (M₁), le dépeuplement de la pompe peut avoir lieu dans le sens dit "Retour" et ainsi permettre le verrouillage du laser (ou diode laser) sur la longueur d'onde recherchée.

Ceci signifie en particulier que le miroir peut être conçu et réalisé par exemple par simple dépôt diélectrique sur la face de sortie d'un substrat supportant le guide au sein duquel se produit l'interaction.

Exemple d'application concernant une source bleue de longueur d'onde 415 nm

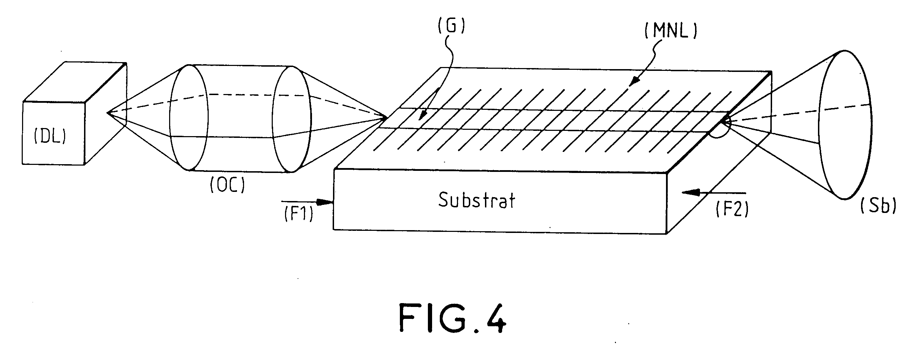

La source bleue est obtenue par doublage de fréquence du faisceau proche infrarouge (longueur d'onde 860 nm) d'une diode laser du type GaAs/GaAlAs. Cette diode est supposée ne présenter qu'un seul mode spatial pour favoriser le couplage de l'énergie lumineuse dans le composant (MNL) doubleur de fréquence. Ce composant peut typiquement être un guide d'onde réalisé sur tantalate de lithium par échange protonique. La référence ("High power blue light generation by frequency doubling of a laser diode in a periodically domain-inverted LiTaO₃ waveguide", K. YAMAMOTO, K. MIZUUCHI, Y. KITAOKA and M. KATO, Appli. Phys. Letter 62 (21), pp. 2599, 2601, 24 May 1993) décrit un tel composant dans lequel la condition de quasi accord de phase (QAP) est assurée par réseau obtenu par retournement du coefficient non-linéaire mis en jeu par des techniques connues (notamment par échange protonique, puis recuit rapide à une température voisine de 600 °C). Le principe général d'une telle source bleue est illustrée en figure 4. Une diode laser (DL) émet une onde de pompe à $\lambda o_i$, qui traverse une optique de couplage (OC) permettant le couplage de ladite onde de pompe au sein d'un guide d'onde (G) réalisé dans le composant (MNL). La face d'entrée (F₁) du composant (MNL) est préalablement soumise à un traitement diélectrique à la longueur d'onde de l'onde de pompe. La face de sortie (F₂) du composant (MNL) subit quant à elle un traitement diélectrique préalable la rendant fortement réfléchissante pour l'onde pompe et fortement transparente pour l'onde harmonique, de manière à constituer le miroir ($M_1$). En sortie du composant (MNL) on est ainsi en mesure de récupérer la source bleue (Sb) de longueur d'onde $\lambda o_a/2$.

Compte tenu du matériau ($LiTaO_3$) constitutif du milieu non linéaire (MNL) et de la longueur d'onde de pompe (860 nm), la période permettant d'assurer la condition de quasi accord de phase (QAP) est de 3,95 µm. L'efficacité expérimentale du doublage de fréquence publiée dans la référence citée précédemment de YAMAMOTO correspond à un rendement normalisé supérieur à 230%/W.cm$^2$. Ce rendement qui n'a de signification que lorsque le dépeuplement de l'onde de pompe est négligeable, est obtenu en divisant la puissance harmonique mesurée à la sortie du doubleur par le carré de la puissance de pompe couplée dans le doubleur et par le carré de la distance d'interaction. A partir de ce rendement de conversion accessible en pratique avec une technologie connue, il est possible d'évaluer le dépeuplement de l'onde de pompe lors de sa réinjection dans la diode, ainsi que la puissance recherchée à la fréquence double en sortie du miroir ($M_1$).

A partir des données numériques suivantes :

- longueur d'onde $\lambda o_a$ de QAP : 860 nm

- puissance de $P_{\omega,0}$ de pompe utilisée : 100 mW

- efficacité de conversion (doublage) : 230 %/W.cm$^2$

  d'un miroir dont les coefficients de réflexion sont
  $R_{2\omega} = 0,01$ pour l'onde harmonique
  $R_\omega = 0,9$ pour l'onde de pompe
  on détermine le tableau ci-dessous en fonction de la longueur d'interaction L, mettant en évidence le dépeuplement de la pompe ($R\omega.P\omega$ correspond à la puissance réinjectée dans le laser à la fréquence $\omega$) ainsi que la puissance créée à la fréquence $2\omega$ en sortie du miroir $M_1$.

| L (cm) | $R\omega.P\omega$ (mW) | $P_{2\omega}$ (mW) |
|--------|------------------------|--------------------|
| 1 | 72,2 | 19,6 |
| 2 | 40,3 | 44,4 |
| 3 | 18,3 | 78,9 |

## Revendications

1. Source optique compacte, comprenant un laser émettant une onde incidente dans une gamme de longueurs d'onde $\lambda o_i$, un milieu non linéaire (MNL), caractérisée en ce que :

   - la condition d'accord de phase permettant d'annuler ou de compenser la différence de constante de propagation existant entre la polarisation non linéaire créée par l'onde incidente d'une part et l'onde harmonique engendrée par cette polarisation d'autre part, est réalisée à la longueur d'onde $\lambda o_a$ appartenant à l'ensemble des $\lambda o_i$, dans le milieu (MNL) ;

   - la source optique comprend également un miroir dichroïque situé de telle manière que le milieu (MNL) est compris entre le laser et le miroir, ledit miroir étant fortement réfléchissant à $\lambda o_i$ et fortement transparent à $\lambda o_i/2$ de façon à réinjecter dans le laser une onde lumineuse dont le niveau énergétique à la longueur d'onde $\lambda o_a$ est fortement dépeuplé par rapport aux niveaux énergétiques aux longueurs d'onde $\lambda o_i \neq \lambda o_a$.

2. Source optique compacte selon la revendication 1, caractérisée en ce que le laser est une diode laser.

3. Source optique compacte selon l'une des revendications 1 ou 2, caractérisée en ce que la condition d'accord de phase permettant d'annuler la différence de constante de propagation existant entre la polarisation non linéaire créée par l'onde incidente, et l'onde incidente est assurée par la biréfringence du milieu (MNL).

4. Source optique compacte selon la revendication 3, caractérisée en ce que le miroir dichroïque introduit un déphasage $\varphi_h$ sur l'onde harmonique et un déphasage $\varphi_p$ sur l'onde de pompe tels $2\varphi_p - \varphi_h \neq \pm \pi$.

5. Source optique compacte selon l'une des revendications 1 ou 2, caractérisée en ce que la condition d'accord de phase permettant de compenser la différence de constante de propagation existant entre la polarisation non linéaire créée par l'onde incidente, et l'onde incidente est assurée par la modulation spatiale périodique d'un paramètre physique du milieu non linéaire (MNL) intervenant dans l'interaction non linéaire entre la polarisation non linéaire créée et l'onde harmonique.

6. Source optique compacte selon la revendication 5, caractérisée en ce que le paramètre modulé périodiquement est le coefficient non linéaire $d_{33}$.

7. Source optique compacte selon l'une des revendications 1 à 6, caractérisée en ce que le milieu (MNL) est un guide d'onde.

8. Source optique compacte selon l'une des revendications 1 à 7, caractérisée en ce que $\lambda o_a$ est voisine de 430 nm, le laser émettant dans le proche infrarouge (vers 860 nm).

9. Source optique compacte selon l'une des revendications 1 à 8, caractérisée en ce que le milieu (MNL) est du tantalate de lithium (LaTiO$_3$).

10. Source optique compacte selon l'une des revendications 1 à 8, caractérisée en ce que le milieu (MNL) est du phosphate de potassium et de titanyl (KTP).

11. Source optique compacte selon l'une des revendications 1 à 8, caractérisée en ce que le milieu (MNL) est du niobate de lithium (LiNbO$_3$).

12. Source optique compacte selon l'une des revendications 1 à 11, caractérisée en ce que le miroir (M$_1$) comprend au moins une couche diélectrique intégrée au milieu (MNL).

FIG.1

Puissance de pompe

(2)

Δλ

Puissance harmonique

$\lambda_{0a}$

$\lambda_\omega$

(longueur d'onde de pompe)

# FIG.2

(MNL)          (M1)

(DL)

$\lambda 0_a / 2$

$\lambda 0_i \neq \lambda 0_a$

# FIG.3

(G)    (MNL)

(DL)

(OC)

(F1)    Substrat    (F2)    (Sb)

FIG.4

EP 0 703 648 A1

EP 0 703 648 A1

**Office européen des brevets**

# RAPPORT DE RECHERCHE EUROPEENNE

Numero de la demande

EP 95 40 2100

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP-A-0 576 197 (MATSUSHITA ELECTRIC IND CO LTD) 29 Décembre 1993<br>* abrégé * | 1-12 | H01S3/109 |
| A | EP-A-0 473 441 (OKI ELECTRIC IND CO LTD) 4 Mars 1992<br>* abrégé * | 1-12 | |
| A | ELECTRONICS LETTERS,<br>vol. 29, no. 18, 2 Septembre 1993<br>page 1629/1630 XP 000395199<br>LEURELL F 'STABLE BLUE SECOND-HARMONIC GENERATION IN A KTP WAVEGUIDE WITH A DIODE LASER IN AN EXTERNAL CAVITY'<br>* figure 1 * | 1-12 | |
| A | APPLIED PHYSICS LETTERS,<br>vol. 63, no. 23, 6 Décembre 1993 NEW YORK US,<br>pages 3134-3136, XP 000414072<br>W.P.RISK ET AL. 'Generation of 425-nm light by waveguide frequency doubling of GaAlAs laser diode in an extended-cavity configuration'<br>* figure 1 * | 1-12 | **DOMAINES TECHNIQUES RECHERCHES (Int.Cl.6)**<br>H01S |

Le présent rapport a été établi pour toutes les revendications

| Lieu de la recherche | Date d'achèvement de la recherche | Examinateur |
|---|---|---|
| LA HAYE | 21 Décembre 1995 | Galanti, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)